# EUROPEAN PATENT APPLICATION

(11) **EP 2 336 611 A1**
(43) Date of publication of application: **22.06.2011**
(21) Application number: 09179339.8
(22) Date of filing: 15.12.2009
(51) Int. Cl.: F16K 1/20, F16K 49/00, F16K 51/02, H01L 21/00

(54) **Water cooled valve**

(71) Applicant: Applied Materials, Inc., Santa Clara, CA 95054 (US)
(72) Inventor: Sauer, Andreas, 63762 Grossostheim (DE); Wurster, Harald, 63776 Moembris (DE); Hoffmann, Josef, 63839 Kleinwallstadt (DE); Goerisch, Goetz, 64297 Darmstadt (DE)
(74) Representative: Zimmermann, Gerd Heinrich

(57) **Abstract**

A lock valve (100) is adapted for locking a process chamber (300). The lock valve (100) includes a valve flap (101) adapted for sealing an aperture (301, 302) of the process chamber (300) where a substrate (500) to be processed may be inserted or ejected. A cooling unit (200) is adapted for cooling the valve flap 101 by means of a cooling fluid. At least one valve flap hinge (105, 106, 108) is adapted for connecting the process chamber 300 with the valve flap 101. The valve flap hinge (105, 106, 108) furthermore includes at least one pipe (201, 202) in fluid communication with the cooling unit (200) of the valve flap (101).

## Description

### TECHNICAL FIELD OF THE INVENTION

Embodiments of the present invention relate to a substrate processing system having a process chamber for processing at least one substrate, and in particular relates to a lock valve for a process chamber. Furthermore, embodiments of the present invention relate to a method for locking a process chamber by means of a valve flap.

### BACKGROUND OF THE INVENTION

Processing of individual substrates in a defined environment is of increasing importance. For example, solar cells are manufactured using substrates coated by appropriate light sensitive layers. These deposition processes are carried out in an environment, i.e., in a substrate environment which may include different types of gases relevant for a layer composition of the respective solar cells. Deposition processes may include, inter alia, plasma-assisted deposition processes. The deposition processes may be performed in a vacuum environment or at defined pressures below atmospheric pressure or at atmospheric pressure.

Furthermore, other substrate processing procedures, such as surface activation, etching processes, etc., may be applied in such kind of environment. In order to provide a predetermined substrate environment, the substrate may be inserted into the process chamber via input units and may be ejected from the process chamber via ejection units. Apertures of the process chamber at the input and ejection units may be closed by means of lock valves.

Lock valves for process chambers may include a vacuum-tight seal in order to retain a vacuum and/or low-pressure environment within the process chamber. In addition to that, deposition processes may be carried out at high temperatures such that the process chamber, or at least components of the process chamber, such as the valve flap, may require cooling by appropriate cooling units.

It is desirable to provide a reliable and cost-effective valve flap adapted for locking a process chamber, and providing easy maintenance and flexible operation.

### SUMMARY OF THE INVENTION

In light of the above, the present invention provides a lock valve in accordance with independent claim 1, and a method for locking a process chamber in accordance with independent claim 12.

According to one embodiment, a lock valve adapted for locking a process chamber is provided, the lock valve including a valve flap adapted for sealing an aperture of the process chamber, a cooling unit adapted for cooling the valve flap by means of a cooling fluid, and at least one valve flap hinge rotatably connecting the process chamber with the valve flap, the valve flap hinge further including a pipe in fluid communication with the cooling unit of the valve flap.

According to another embodiment, a method for locking a process chamber is provided, the method including providing a valve flap mounted at the process chamber by means of a valve flap hinge, tilting the valve flap about a valve flap hinge axis between an open valve position and a closed valve position, and flowing cooling fluid through the valve flap hinge concentrically to the valve flap hinge axis, to a cooling unit mounted at the valve flap.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
- Figure 1A: shows a schematic side view of a process chamber having a valve flap according to a typical embodiment;
- Figure 1B: shows a schematic side view of two process chambers interconnected by a flange, according to another typical embodiment;
- Figure 2: is front view of a process chamber where a substrate to be processed is inserted, seen in the substrate transport direction;
- Figure 3: illustrates a valve flap with cooling channels and cooling fluid inlet and outlet pipes, according to a typical embodiment;
- Figure 4: illustrates a valve flap having cooling channels and cooling fluid inflows and outflows, according to another typical embodiment;
- Figure 5: is a detailed side-sectional view of a portion of the process chamber, a valve flap and a valve flap driving unit;
- Figure 6: is a detailed side-sectional view of a valve flap having cooling fluid inflows and outflows, and being driven by a valve flap driving unit; and
- Figure 7: is a flowchart illustrating a method for locking a process chamber by means of a valve flap.

### DETAILED DESCRIPTION OF THE EMBODIMENTS

Reference will now be made in detail to the various embodiments of the invention, one or more examples of which are illustrated in the figures. Within the following description of the drawings, the same reference numbers refer to the same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer inter alia to a substrate processing system adapted for processing substrates such as solar wafers in a defined substrate environment. In particular, embodiments described herein refer to a process chamber adapted for receiving a substrate to be processed, the process chamber having a lock valve for providing a substrate environment within the process chamber which is isolated from an outer environment, i.e., an outer atmosphere. A substrate environment within the process chamber may be a vacuum or a low pressure atmosphere.

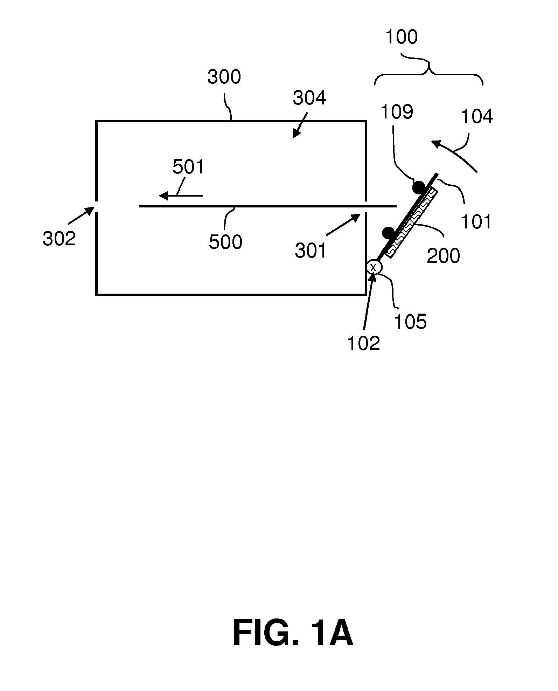

Fig. 1A is a schematic side-sectional view of a process chamber 300 adapted for receiving a substrate 500 to be processed. The process chamber 300 includes a substrate insertion slot 301 and a substrate ejection slot 302. At the substrate insertion slot 301, a substrate 500 to be processed may be inserted in a substrate transport direction 501. At the substrate ejection slot 302, the processed substrate 500 may be ejected in the substrate transport direction 501. As shown in Fig. 1A, the substrate insertion slot 301 may be closed by a lock valve 100.

It is noted here, although not shown in Fig. 1A, that the lock valve 100 may also be installed at the substrate ejection slot 302 or at both the substrate insertion slot 301 and the substrate ejection slot 302, in order to provide a defined substrate environment 304 within the process chamber 300.

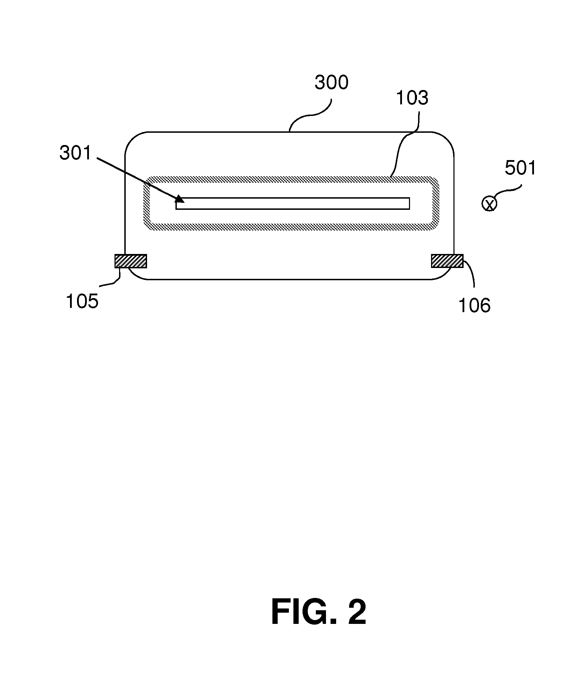

The lock valve 100 includes a valve flap 101 which may be rotated about a hinge axis 102 of a valve flap hinge 105. In order to seal the process chamber 300, the valve flap 101 of the lock valve 100 may further include an o-seal 109 which is arranged around the substrate insertion slot 301 when the valve flap 101 is closed, as will be described herein below with respect to Fig. 2. Thus, the valve flap 101 may be rotated about the axis 102 of the valve flap hinge 105 in a closing direction 104 such that the substrate insertion slot 301 is sealed. The same may apply, as mentioned above, to the substrate ejection slot 302, by providing another lock valve 100 at the location of the ejection slot. As shown in Fig. 1A, the o-seal 109 may be attached at the valve flap 101 and, thus, may abut on a flat side surface of the process chamber 300 around the substrate insertion slot 301 when the valve flap 101 is closed. According to an alternative embodiment, the o-seal 109 may be attached in a groove at the side surface of the process chamber 300 and the valve flap 101 may have a flat surface at which the o-seal 109 abuts when the valve flap 101 is closed.

According to an alternative embodiment, which may be combined with other embodiments described herein, the valve flap hinge 105 may be installed at an upper position above the substrate insertion slot 301 shown in Fig. 1A, such that the valve flap 101 of the lock valve 100 is rotated about the valve flap hinge axis 102 which is above the substrate insertion slot 301. The valve flap hinge 105 may include a first hinge portion adapted for being mounted at the process chamber 300, and a second hinge portion adapted for being mounted at the valve flap 101.

The second hinge portion may be rotated with respect to the first hinge portion about the valve flap hinge axis 102. The valve flap 101 shown in Fig. 1A provides a secure and easy operation such that the o-seal 109 of the lock valve 100 is not twisted while the valve flap 101 is moved between an open valve position and a closed valve position in a closing direction 104. The valve flap typically may be rotated about the valve flap hinge axis 102 by an angle in a range from 30 degrees to 100 degrees, and typically by an angle of 90 degrees.

When the valve flap 101 is in the closed valve position, the substrate insertion slot 301, i.e., an aperture through which the substrate 500 to be processed is inserted, may be sealed, such that the substrate environment 304 is separated from the outside environment surrounding the process chamber 300. Thus, an aperture of the process chamber 300, such as the substrate insertion slot 301, and the substrate ejection slot 302, may be sealed by respective lock valves 100.

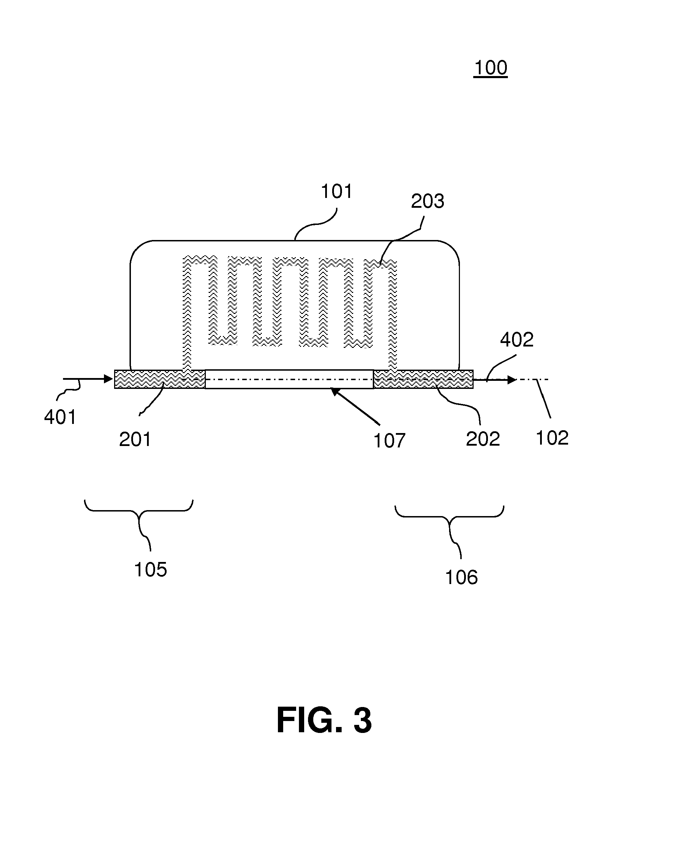

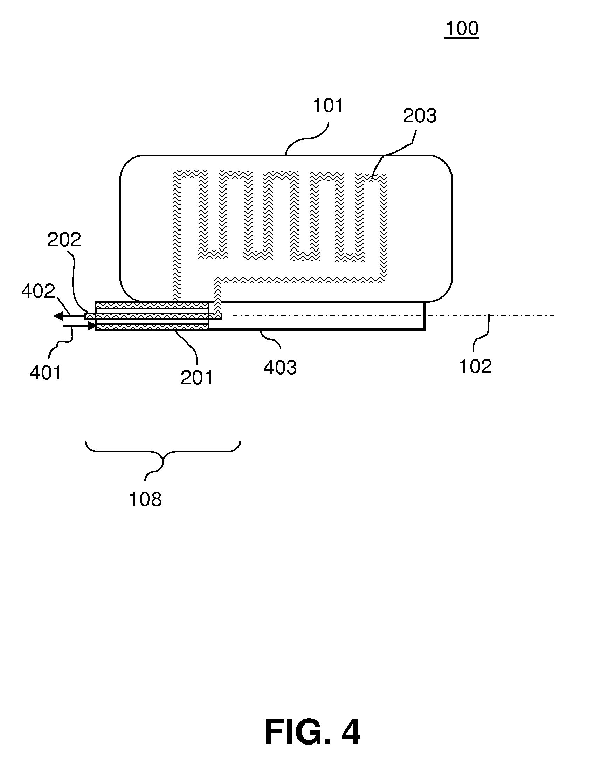

As mentioned above, substrate processing may take place at an elevated temperature such that valves and/or valve flaps 101 of respective lock valves 100 may require cooling. As indicated in Fig. 1A, the valve flap 101 of the lock valve 100 includes a cooling unit 200 operating with a cooling fluid, e.g., with cooling water. A flow of the cooling fluid to the cooling unit 200 will be described herein below with respect to Figs. 3 and 4.

The valve flap hinge 105 rotatably connects the process chamber 300 with the valve flap 101. If the valve flap is in the closed valve position, a vacuum-tight seal of the process chamber 300 may be provided.

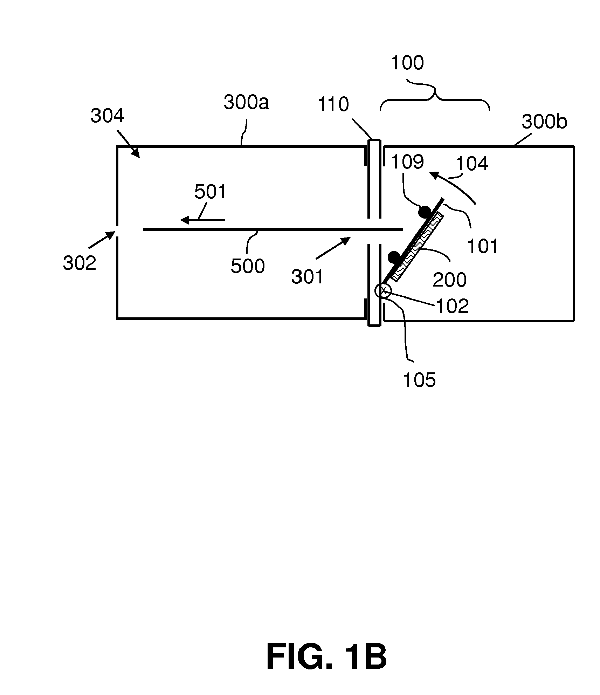

Fig. 1B shows a schematic side view of two process chamber 300a, 300b interconnected by a flange 110, according to another typical embodiment. The valve flap 101 is shown to be attached at a flange 110 arranged between the process chambers 300a, 300b, e.g., an intermediate flange. The flange 110 is provided, e.g., in order to facilitate the manufacture of process chambers and/or in order to facilitate a connection of adjacent process chambers. Furthermore, the flange 110 can be used at one or both ends of an individual chamber or may be arranged between two portions of the same process chamber 300, or between two process chambers 300a, 300b. The manufacturing of the valve flap connection to the flange might, depending on the application, be easier than providing the manufacturing directly at the chamber.

As illustrated in Fig. 1B, the valve flap 101 of the lock valve 100 projects into the interior of the second process chamber 300b when the valve flap 101 is moved from the closed valve position to the open valve position. Seals may be provided between the process chambers 300a, 300b and the flange 110, respectively, such that the two process chambers 300a, 300b may both have a vacuum-tight connection to the flange 110 and with respect to each other.

Fig. 2 is a front view of a process chamber 300 according to a typical embodiment. The substrate 500 to be processed is transported in a substrate transport direction 501 in a direction towards the substrate insertion slot 301. Around the substrate insertion slot 301, an o-seal insertion slot 103 is arranged. Into this o-seal insertion slot 103 which may be provided as a groove, an o-seal 109 (Fig. 1A) may fit in such that, if the valve flap 101 (not shown in Fig. 2) is closed, a vacuum-tight seal of the process chamber 300 is achieved. According to an alternative embodiment, the side face of the process chamber 300 may be provided with a flat surface, i.e., without groove 103 such that the o-seal 109 arranged at the valve flap 101 abuts on a plane when the valve flap 101 is closed. According to yet a further embodiment not shown in the drawings, the o-seal 109 may be arranged at the side face of the process chamber 300 and the valve flap 101 abuts on the o-seal 109 when the valve flap 101 is closed. Here again, the valve flap 101 may have a flat surface, or alternatively, a groove which may be in contact with the o-seal 109 when the valve flap 101 is closed.

At the side of the process chamber 300, at which the valve flap 101 is mounted, two flap hinges, i.e., a first valve flap hinge 105 and a second valve flap hinge 106, are provided. These valve flap hinges 105, 106 are adapted to rotatably hold the valve flap 101. The valve flap 101 typically has a width in the range from 500 mm to 3500 mm, and typically has a width of approximately 2900 mm. The valve flap 101 may have a height in the range from 50 mm to 150 mm, and typically has a height of approximately 120 mm.

It is noted here that the first valve flap hinge 105 and/or the second valve flap hinge 106 may be dismounted from the process chamber 300 such that no components are protruding from the process chamber 300 and a safe shipping of the entire unit may be provided. In addition to that, an easy and cost-effective installation of the valve flap 101 at the process chamber 300 is possible.

The o-seal 109 is adapted to be inserted into the o-seal insertion slot 103. For example, the o-seal insertion slot 103 may have a depth of half the diameter of the o-seal 109 such that approximately half of the o-seal 109 protrudes from the surface of the process chamber 300 facing the valve flap 101. This arrangement of the o-seal 109 within the o-seal insertion slot 109 ensures that a twist of the o-seal 109 during closing the valve flap 101 is reduced. On the other hand, twisting of the o-seal 109 may be completely avoided. Torsion-free operation of the o-seal 109 results in lower maintenance costs and an enhanced durability because abrasion is reduced.

Fig. 3 is a schematic view of a lock valve 100 according to a typical embodiment. The lock valve 100 includes the valve flap 101 which is provided with a cooling unit 200 (see Fig. 1A herein above). In the embodiment shown in Fig. 3, which may be combined with other embodiments described herein, the cooling unit 200 includes a cooling channel 203 which may be provided within the valve flap 101. Alternatively, the cooling channel 203 may be provided as a pipe adapted for being attached at and in thermal contact with the valve flap 101. Both ends of the cooling channel 203 are in fluid communication with a cooling fluid inflow 401 and a cooling fluid outflow 402, respectively.

The cooling fluid inflow 401 is provided by a cooling fluid inlet pipe 201 and adapted for flowing fluid towards the cooling channel 203. The cooling fluid outflow 402 is provided by a cooling fluid outlet pipe 202 and is adapted for ejecting cooling fluid from the cooling channel 203. A flap shaft 107 is connected to the valve flap 101 and is adapted for holding the valve flap rotatably at the valve flap hinges 105, 106 (see Fig. 2 herein above).

As illustrated in Fig. 3, at least one of the first valve flap hinge 105 and the second valve flap hinge 106 is adapted for rotatably connecting the process chamber 300 with the valve flap 101. The valve flap hinge 105, 106 further includes the pipes 201, 202, respectively in fluid communication with the cooling unit 200 of the valve flap 101.

In dependence of a desired application of the lock valve 100, cooling fluid inflow 401 and cooling fluid outflow 402 may also be reversed such that cooling fluid enters the valve flap 101 from the right side in Fig. 3 and is ejected at the left side in Fig. 3, respectively. Flexible cooling pipes may be avoided, because cooling fluid is flown within the valve flap hinge 105, i.e., concentrically to the valve flap hinge axis 102 into and out of the cooling unit 200 of the valve flap 101.

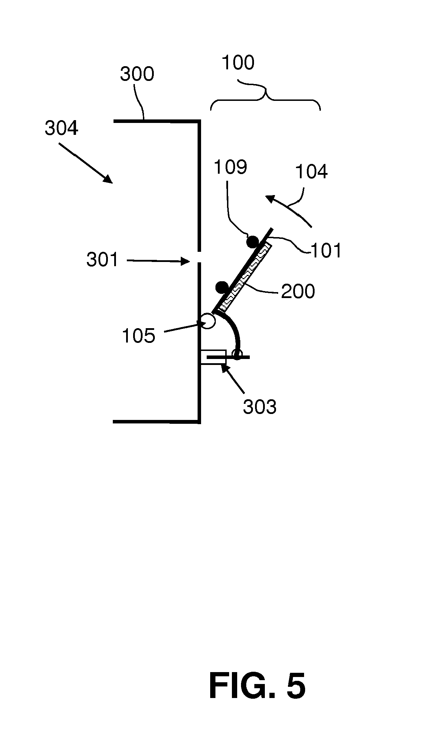

Thus, twisting of cooling pipes is reduced and an easy maintenance is achieved. As a flexible cooling connection is not required, the number of required components for the cooling unit is further reduced. The inlet and outlet pipes 201, 202 for the cooling fluid are thus arranged within the valve flap hinge axis 102, e.g., concentrically to the valve flap hinge axis 102. A rigid connection of the flap shaft 107 to the valve flap 101 may be provided. Thus, the first and second valve flap hinges 105, 106, respectively, are adapted to both transfer cooling fluid and provide a bearing for a rotation by means of the driving unit (described herein below with respect to Fig. 5).

At least one of the cooling fluid inlet pipe 201 and the cooling fluid outlet pipe 202 are arranged around the valve flap hinge axis 102, e.g., concentrically to the valve flap hinge axis 102. Furthermore, the flap shaft 107 may be mounted concentrically to the valve flap hinge axis 102 such that cooling fluid may be provided via rigid, rotatably connected pipes.

According to Fig. 3, two valve flap hinges 105, 106 are provided. The first valve flap hinge 105 is provided for the inflow of a cooling fluid to the cooling unit 201, wherein the second valve flap hinge 106 is provided for an outflow of cooling fluid from the cooling unit 200. The valve flap 101 and the cooling unit 200 (see Fig. 1A) may be provided as an integral unit as shown in Fig. 3. Here, the cooling unit 200 is provided in the form of cooling channels 203 within the valve flap 101. The cooling unit 200 may include a meander-shaped internal cooling channel 203, as schematically indicated in Fig. 3.

Fig. 4 is a schematic view of a lock valve 100 according to another typical embodiment. As shown in Fig. 4, the valve flap 101 is rotatably connectable to a process chamber 300 (not shown in Fig. 4) by means of a double pipe valve flap hinge 108. The double pipe valve flap hinge 108 includes inflows and outflows arranged within the valve flap hinge 108, e.g., concentrical inflows and outflows for the cooling fluid. For example, a cooling fluid inflow 401 is provided by means of a cooling fluid inlet pipe 201 which is arranged concentrically around a cooling fluid outlet pipe 202 which provides the cooling fluid outflow 402.

Both the cooling fluid inlet pipe 201 and the cooling fluid outlet pipe 202 are arranged concentrically with respect to the valve flap hinge axis 102 of the double pipe valve flap hinge 108. As compared to the embodiment described herein above and illustrated in Fig. 3, the second embodiment of the lock valve 100 described with respect to Fig. 4 has a reduced number of components for operation.

The valve flap 101 is rotatably supported at one side of a flap shaft 403. The lock valve 100 according to the second embodiment includes a double pipe valve flap hinge 108 which may provide three different operation functions at the same time: (i) cooling fluid inflow; (ii) cooling fluid outflow; and (iii) a bearing for tilting the valve flap between an open valve position and a closed valve position by means of an external valve flap driving unit 303 which is described herein below with respect to Fig. 5.

Thus, according to the arrangement shown in Fig. 4, at least one flap hinge is provided as a double pipe valve flap hinge including the inlet pipe 201 for flowing the cooling fluid towards the cooling unit 201 and, further, including the outlet pipe 202 adapted for flowing the cooling fluid from the cooling unit 200.

Fig. 5 is a side-sectional view illustrating an operation of the valve flap 101 with respect to the process chamber 300. In Fig. 5, a portion of the process chamber 300 is shown to include the substrate insertion slot 301. When the valve flap 101 has been moved from the open valve position to the closed valve position in a closing direction 104, the substrate environment, i.e., the process environment 304, in the inner region of the process chamber 300 is sealed with respect to an atmosphere outside the process chamber 300.

According to the typical embodiment illustrated in Fig. 5, the lock valve 100 includes a valve flap driving unit 303 which acts upon the valve flap 101 such that the valve flap 101 may be rotated about the valve flap hinge axis 102 (see Fig. 4 and related description herein above) of the valve flap hinge 105 due to the effect of a force transferred by the valve flap driving unit 303. In the closed valve position, the o-seal 109 is close-fitting at the wall of the process chamber 300 such that a vacuum-tight seal is provided.

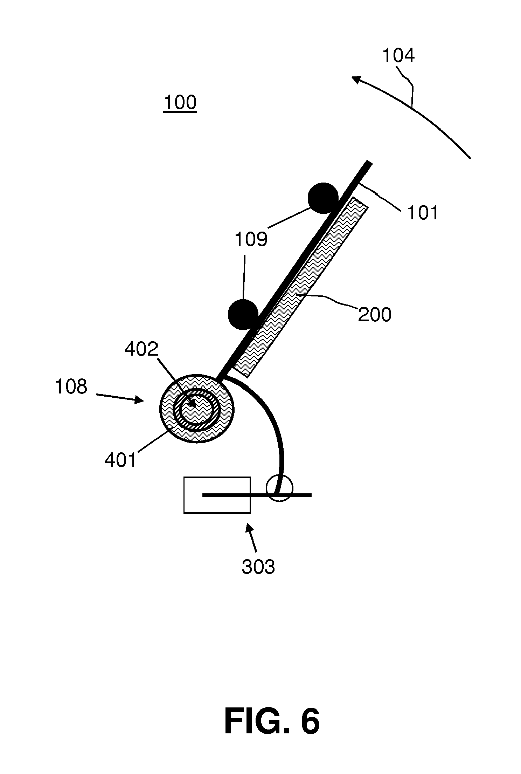

It is noted here, although not shown in the drawings, that the o-seal 109 may also be attached at a side of the process chamber 300 such that the valve flap 101 is adjacent to the o-seal 109 only in the closed valve position. The valve flap driving unit 303 is adapted to rotate the valve flap 101 about the valve flap hinge axis 102. Cooling fluid inflow and outflow is detailed with respect to Fig. 6 herein below.

Fig. 6 is a detailed side-sectional view of a lock valve 100 according to a typical embodiment. As shown in Fig. 6, the valve flap 101 may be tilted from an open valve position towards a closed valve position in the closing direction 104 by means of the valve flap driving unit 303. When closing the valve flap 101 in the closing direction 104, the valve flap 101 is rotated about the axis of the double pipe valve flap hinge 108.

The double pipe valve flap hinge 108 includes, as has been described herein above with respect to Fig. 4, a cooling fluid inlet pipe 201 and a cooling fluid outlet pipe 202 arranged concentrically with respect to each other. Thus, a cooling fluid inflow may be provided at an outer part of the valve flap hinge, wherein a cooling fluid outflow 402 may be provided at an inner part of the valve flap hinge 108. It is noted that components which have been described already with reference to previous drawings are not described here in order to avoid a redundant description.

The o-seal 109 is seen to be attached at a side of the valve flap 101 facing the wall of the process chamber 300 (not shown in Fig. 6). The valve flap driving unit 303 may include a pneumatically actuated cylinder arrangement, the piston of which moves back and forth and is connected to the valve flap 101 by means of a link arrangement shown in Fig. 6.

Thus, the valve flap driving unit 303 is adapted for tilting the valve flap 101 of the lock valve 100 between an open valve position (shown in Fig. 6) and a closed valve position. During a movement from the open valve position towards the closed valve position, the o-seal 109 arranged at the valve flap 101, e.g., arranged within a groove provided at the valve flap 101 is pressed torsion-free against the process chamber 300 and may fit, around the aperture of the process chamber 300 in an o-seal insertion slot 103 at the side of the process chamber 300 (see Fig. 2). It is noted here that the groove where the o-seal 109 may be arranged in order to provide an appropriate fixture of the o-seal 109, even during movement of the valve flap 101, may have a trapezoidal cross-sectional shape. According to an alternative embodiment, the side face of the process chamber 300 where the valve flap 101 is attached may be provided with a flat surface, i.e., without groove 103 such that the o-seal 109 arranged at the valve flap 101 abuts on a plane when the valve flap 101 is closed.

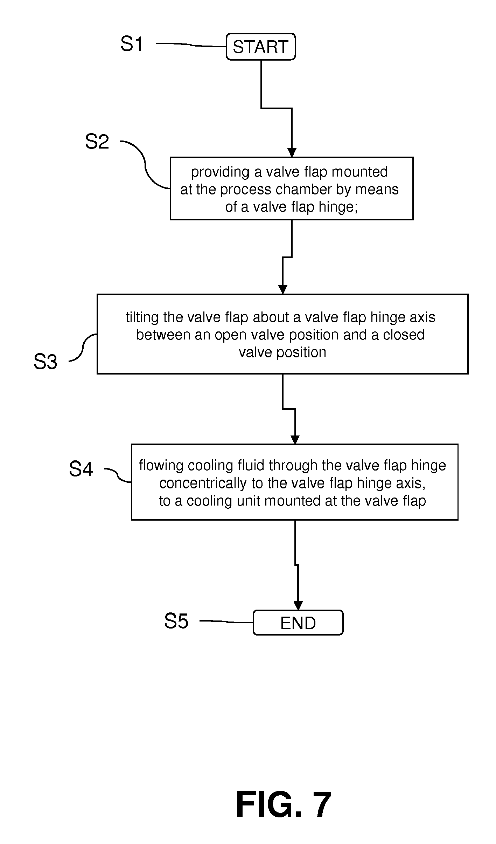

Fig. 7 is a flowchart illustrating a method for locking the process chamber 300. At a block S1, the method is started. At a block S2, a valve flap 101 is provided which is mounted at a side of the process chamber 300 where an aperture (substrate insertion slot) 301 is located. The valve flap 101 is attached at the process chamber 303 by means of at least one valve flap hinge 105, 106, 108.

At a block S3, the valve flap 101 may be tilted about the valve flap hinge axis 102 between an open valve position and a closed valve position. In addition to that, cooling fluid is flown through the valve flap hinge 105, 106, 108 concentrically to the valve flap hinge axis 102 at a block S4. The cooling fluid is flown towards a cooling unit 200 integrated in the valve flap 101. The procedure is ended at a block S6.

In light of the above, a plurality of embodiments has been described. For example, according to one embodiment, a lock valve adapted for locking a process chamber is provided The lock valve includes a valve flap adapted for sealing an aperture of the process chamber, a cooling unit adapted for cooling the valve flap by means of a cooling fluid, and at least one valve flap hinge rotatably connecting the process chamber with the valve flap, the valve flap hinge further including a pipe in fluid communication with the cooling unit of the valve flap. According to an optional modification thereof, the pipe is arranged concentrically to a valve flap hinge axis of the valve flap hinge. According to different embodiments, which can be combined with other embodiments described herein, at least two valve flap hinges are provided, wherein a first valve flap hinge of the at least two valve flap hinges is provided for an inflow of cooling fluid to the cooling unit, and a second valve flap hinge of the at least two valve flap hinges is provided for an outflow of cooling fluid from the cooling unit. According to yet further embodiments, which can be combined with other embodiments described herein, the at least one flap hinge is provided as a double pipe valve flap hinge including an inlet pipe adapted for flowing the cooling fluid towards the cooling unit, and further including an outlet pipe adapted for flowing the cooling fluid from the cooling unit. Furthermore, the lock valve in accordance with claim 1, wherein the valve flap and the cooling unit are formed as an integral unit. According to yet further additional or alternative modifications, the cooling unit includes a meander shaped internal cooling channel. Moreover, an o-seal is provided which is arranged around the aperture and adapted for sealing the aperture of the process chamber when the lock valve is in the closed valve position. The o-seal may be arranged at a side of the valve flap opposing the process chamber when the valve flap is in the closed valve position. According to yet further embodiments, which can be combined with other embodiments described herein, the lock valve includes a valve flap driving unit connected to the valve flap and being adapted for tilting the valve flap between an open valve position and a closed valve position. According to yet further additional or alternative modifications, the valve flap has a width in the range from 500 mm to 3500 mm, and typically has a width of approximately 2900 mm. Furthermore, the valve flap has a height in the range from 50 mm to 150 mm, and typically has a height of approximately 120 mm. The valve flap hinge may include a first hinge portion adapted for being mounted at the process chamber, and a second hinge portion adapted for being mounted at the valve flap. According to a typical embodiment, the valve flap is adapted for providing a vacuum-tight sealing of the process chamber. According to yet further embodiments, which can be combined with any of the other embodiments and modifications above, the lock valve further includes a flap shaft adapted for holding the valve flap at the at least one valve flap hinge, the flap shaft being arranged concentrically to the valve flap hinge axis of the valve flap hinge and being connected to the valve flap hinge. According to another embodiment, a method for locking a process chamber is provided. The method includes providing a valve flap mounted at the process chamber by means of a valve flap hinge, tilting the valve flap about a valve flap hinge axis between an open valve position and a closed valve position, and flowing cooling fluid through the valve flap hinge concentrically to the valve flap hinge axis, to a cooling unit mounted at the valve flap. According to yet further additional or alternative modifications a vacuum-tight seal of the process chamber is provided when the valve flap is in the closed valve position. In addition to that, or alternatively, an o-seal provided at the valve flap is pressed torsion-free against the process chamber around the aperture of the process chamber. The valve flap may be pneumatically actuated by means of a valve flap driving unit. According to yet further embodiments, which can be combined with any of the other embodiments and modifications above, the valve flap hinge at the same time provides the operation functions of a cooling fluid inflow, of a cooling fluid outflow, and of a bearing for tilting the valve flap between the open valve position and the closed valve position. The valve flap may be rotated about the valve flap hinge axis by an angle in a range from 30 degrees to 100 degrees, and typically by an angle of 90 degrees.

While the foregoing is directed to embodiments of the invention, other and further embodiments of the invention may be devised without departing from the basic scope thereof, and the scope thereof is determined by the claims that follow.

## Claims

1. A lock valve adapted for locking a process chamber, the lock valve comprising
a valve flap adapted for sealing an aperture of the process chamber;
a cooling unit adapted for cooling the valve flap by means of a cooling fluid; and
at least one valve flap hinge rotatably connecting the process chamber with the valve flap, the valve flap hinge further comprising a pipe in fluid communication with the cooling unit of the valve flap.

2. The lock valve in accordance with claim 1, wherein the pipe is arranged concentrically to a valve flap hinge axis of the valve flap hinge.

3. The lock valve in accordance with claim 1 or 2, wherein at least two valve flap hinges are provided, and wherein a first valve flap hinge of the at least two valve flap hinges is provided for an inflow of cooling fluid to the cooling unit, and wherein a second valve flap hinge of the at least two valve flap hinges is provided for an outflow of cooling fluid from the cooling unit.

4. The lock valve in accordance with any of the preceding claims, wherein the at least one flap hinge is provided as a double pipe valve flap hinge comprising an inlet pipe adapted for flowing the cooling fluid towards the cooling unit, and further comprising an outlet pipe adapted for flowing the cooling fluid from the cooling unit.

5. The lock valve in accordance with any of the preceding claims, wherein the valve flap and the cooling unit are formed as an integral unit.

6. The lock valve in accordance with any of the preceding claims, wherein the cooling unit comprises a meander shaped internal cooling channel.

7. The lock valve in accordance with any of the preceding claims, wherein an o-seal is provided which is arranged around the aperture and adapted for sealing the aperture of the process chamber when the lock valve is in the closed valve position.

8. The lock valve in accordance claim 7, wherein the o-seal is arranged at a side of the valve flap opposing the process chamber when the valve flap is in the closed valve position.

9. The lock valve in accordance with any of the preceding claims, further comprising a valve flap driving unit connected to the valve flap and being adapted for tilting the valve flap between an open valve position and a closed valve position.

10. The lock valve in accordance with any of the preceding claims, wherein the valve flap has a width in the range from 500 mm to 3500 mm, and typically has a width of approximately 2900 mm.

11. The lock valve in accordance with any of the preceding claims, wherein the valve flap has a height in the range from 50 mm to 150 mm, and typically has a height of approximately 120 mm.

12. A method for locking a process chamber, the method comprising:
providing a valve flap mounted at the process chamber by means of a valve flap hinge;
tilting the valve flap about a valve flap hinge axis between an open valve position and a closed valve position; and
flowing cooling fluid through the valve flap hinge concentrically to the valve flap hinge axis, to a cooling unit mounted at the valve flap.

13. The method in accordance with claim 12, wherein a vacuum-tight seal of the process chamber is provided when the valve flap is in the closed valve position.

14. The method in accordance with claim 12 or 13, wherein an o-seal provided at the valve flap is pressed torsion-free against the process chamber around the aperture of the process chamber.

15. The method in accordance with any of the claims 12 to 14, wherein the valve flap is pneumatically actuated by means of a valve flap driving unit.
